# EUROPÄISCHE PATENTSCHRIFT

(11) **EP 4 029 357 B1**
(45) Veröffentlichungstag und Bekanntmachung des Hinweises auf die Patenterteilung: **17.07.2024**
(21) Anmeldenummer: 20768502.5
(22) Anmeldetag: 01.09.2020
(51) Int. Cl.: H05K 7/20

(54) **ELEKTROGERÄT UND VERFAHREN ZUM HERSTELLEN EINES ERSTEN UND ZWEITEN ELEKTROGERÄTS AUS EINEM BAUKASTEN**
ELECTRICAL DEVICE AND METHOD FOR PRODUCING A FIRST AND SECOND ELECTRICAL DEVICE FROM A KIT
DISPOSITIF ÉLECTRIQUE ET PROCÉDÉ DE FABRICATION D'UN PREMIER ET D'UN DEUXIÈME DISPOSITIF ÉLECTRIQUE À PARTIR D'UN KIT

(30) Priorität: 12.09.2019 DE 102019006434
(43) Veröffentlichungstag der Anmeldung: 20.07.2022
(73) Patentinhaber: SEW-EURODRIVE GmbH & Co. KG, 76646 Bruchsal (DE)
(72) Erfinder: SCHÖRNER, Martin, 76646 Bruchsal (DE); WETZEL, Thomas, 76698 Ubstadt-Weiher (DE); JANZER, Rolf, 76646 Bruchsal (DE)
(86) Internationale Anmeldenummer: PCT/EP2020/025394
(87) Internationale Veröffentlichungsnummer: WO 2021/047793

(56) Entgegenhaltungen:
- WO-A1-2018/174470
- CN-A- 108 432 113
- JP-A- 2014 110 734
- US-A1- 2003 000 080
- US-A1- 2004 252 461
- US-A1- 2007 258 194
- US-A1- 2014 198 454
- US-A1- 2016 218 454
- US-B1- 7 952 879
- US-S- D 609 198

## Beschreibung

Die Erfindung betrifft ein Elektrogerät und ein Verfahren zum Herstellen eines ersten und zweiten Elektrogeräts aus einem Baukasten.

Elektrogeräte mit Kühlkörper sind allgemein bekannt.

Aus der US 2004 / 0 252 461 A1 ist hierzu ist eine Kühlanordnung mit Befestigungsrahmen bekannt.

Aus der US 2001 / 0 026 440 A1 ist eine Anordnung zum Abschirmen unerwünschter elektromagnetischer Strahlung bekannt.

Aus der US 6 639 800 B1 ist eine Kühlanordnung mit mehreren Befestigungspunkten bekannt.

Aus der DE 10 2019 001 113 A1 ist eine Elektrogeräteanordnung, aufweisend ein an einem Tragelement befestigbares Elektrogerät, bekannt.

Aus der DE 20 2008 001 996 U1 ist eine Positionierungsvorrichtung für Wärmesenke bekannt.

Aus der US 6 442 045 B1 ist eine Kühlanordnung für einen integrierten Schaltkreis bekannt.

Aus der US 837 753 S ist eine Wärmesenke bekannt.

Aus der DE 10 2011 010 429 A1 ist ein elektrisches Gerät, insbesondere Umrichter, bekannt.

**Aus der** US 7 952 879 B1 **ist als nächstliegender Stand der Technik ist ein System für effizientes Entwärmen eines Elektronikmoduls bekannt.**

**Aus der** US 2007/258194 A1 **ist eine Motorsteuerung bekannt.**

**Aus der** US 2003/000080 A1 **ist ein Halteteil für die Installation eines Multichipmoduls bekannt.**

**Aus der** JP 2014 110734 A **ist eine Kühlanordnung für eine elektronische Einheit bekannt.**

Der Erfindung liegt daher die Aufgabe zugrunde, ein Elektrogerät kostengünstig herstellbar auszubilden.

Erfindungsgemäß wird die Aufgabe bei dem Elektrogerät nach den in Anspruch 1 und bei dem Verfahren nach den in Anspruch 13 angegebenen Merkmalen gelöst.

Wichtige Merkmale der Erfindung bei dem Elektrogerät, insbesondere Wechselrichter oder Umrichter, sind, dass das Elektrogerät einen eine Kontaktfläche aufweisenden Kühlkörper aufweist, auf welchem ein Leistungsmodul angeordnet ist, insbesondere mit zwischen Kontaktfläche und Leistungsmodul zwischengeordneter Wärmeleitpaste,
wobei ein Rahmenteil des Elektrogeräts auf der Kontaktfläche angeordnet, insbesondere aufgelegt ist, wobei das Leistungsmodul im Rahmenteil aufgenommen ist,
wobei das Rahmenteil durch einen am Rand der Kontaktfläche hervorragenden Wulst des Kühlkörpers begrenzt ist,
insbesondere wobei der Kühlkörper metallisch und das Rahmenteil aus Kunststoff, insbesondere als Spritzgussteil, ausgeführt ist.

Von Vorteil ist dabei, dass eine große Varianz von Elektrogeräten aus einem Baukasten mit nur einer geringen Anzahl von Komponenten herstellbar ist. Indem ein Rahmenteil verwendet wird, ist ein kleineres Leistungsmodul auf der Kontaktfläche aufbringbar als bei Weglassen des Rahmenteils auf der Kontaktfläche anordenbar ist.

Bei einer vorteilhaften Ausgestaltung ist das Leistungsmodul mit einer auf der von der Kontaktfläche abgewandten Seite des Leistungsmoduls angeordneten Leiterplatte elektrisch verbunden,

insbesondere wobei Kontakte des Leistungsmoduls zur elektrischen Kontaktierung auf Leiterbahnen der Leiterplatte gedrückt angeordnet sind. Von Vorteil ist dabei, dass durch Andrücken der Leiterplatte an die federnd ausgeführten oder gelagerten Kontakte des Leistungsmoduls die elektrische Kontaktierung bewirkt wird. Es ist also keine Lötverbindung notwendig und somit ist das Leistungsmodul in einem ersten Herstellschritt auf der Kontaktfläche anordenbar und in einem nachfolgenden zweiten Herstellverfahrensschritt die Leiterplatte aufsetzbar und am Kühlkörper anschraubbar und/oder eine Halteplatte auf die Leiterplatte aufsetzbar und mittels eines Schraubenkopfes einer Schraube andrückbar, welche in eine Gewindebohrung des Leistungsmoduls eingeschraubt wird. Dabei ist das Leistungsmodul mittels am Leistungsmodul angeformter und hervorstehender Positionierstifte relativ zur Leiterplatte positionierbar, wobei die Positionierstifte wie auch die Schraube durch jeweilige Ausnehmungen der Leiterplatte hindurchgehen.

Bei einer vorteilhaften Ausgestaltung ist auf der von dem Leistungsmodul abgewandten Seite der Leiterplatte eine Halteplatte angeordnet, welche, insbesondere von einem Schraubenkopf einer in eine Gewindebohrung des Leistungsmoduls, zumindest teilweise eingeschraubten Schraube auf die Leiterplatte gedrückt wird, insbesondere welche somit auf das Leistungsmodul gedrückt wird. Von Vorteil ist dabei, dass ein Andrücken der Kontakte des Leistungsmoduls an Leiterbahnen der Leiterplatte in einfacher Weise ermöglicht ist.

Bei einer vorteilhaften Ausgestaltung weist das Rahmenteil an seiner Innenseite zum Leistungsmodul hin hervorragende Vorsprünge, insbesondere Nasen, auf,
insbesondere wobei mehrere der Vorsprünge das Leistungsmodul berühren. Von Vorteil ist dabei, dass die Vorsprünge näherungsweise Punktberührung ermöglichen und federnd angeordnet sind. Somit ist ein elastisches Zentrieren des Leistungsmodules an der Kontaktfläche ausführbar.

Bei einer vorteilhaften Ausgestaltung ist das Leistungsmodul an der Innenseite des Rahmenteils aufgenommen und die Außenseite des Rahmenteils vom Kühlkörper, insbesondere vom Wulst, aufgenommen. Von Vorteil ist dabei, dass das Rahmenteil zwischengeordnet ist zwischen dem um die Kontaktfläche unterbrochen umlaufenden Wulst und dem Leistungsmodul. Somit ist das Rahmenteil selbst aufgelegt auf der Kontaktfläche mittels Positionierstiftbereichen abgestützt an der Leiterplatte und nimmt das Leistungsmodul auf und zentriert es. Selbst wiederum ist das Rahmenteil mittels ebensolcher Punktberührung ermöglichenden Vorsprünge am unterbrochen um die Kontaktfläche umlaufenden Wulst abgestützt. Der Wulst ist also in Umfangsrichtung um die Kontaktfläche herum nicht ununterbrochen ausgeführt, sondern mit Unterbrechungen.

Bei einer vorteilhaften Ausgestaltung ist jeder der Vorsprünge an einem jeweiligen Steg angeformt, welcher einen jeweiligen Schlitz begrenzt,
insbesondere wobei der jeweilige Schlitz in der vom Schlitz zum Vorsprung gerichteten Richtung weniger ausgedehnt ist als in der zur Richtung senkrechten Richtung. Von Vorteil ist dabei, dass der Steg dünn ist und somit elastisch verformbar, so dass der Vorsprung ebenfalls elastisch verformbar ist.

Bei einer vorteilhaften Ausgestaltung weist das Rahmenteil an seiner Außenseite zum am Kühlkörper ausgeformten Wulst hin hervorragende Vorsprünge, insbesondere Nasen, auf,
insbesondere wobei mehrere dieser Vorsprünge den Wulst berühren,
insbesondere wobei der Wulst mehrstückig, also mehrteilig, ausgebildet ist. Von Vorteil ist dabei, dass die Vorsprünge elastisch gefedert angeordnet sind und somit die Zentrierung elastisch bewirken.

Bei einer vorteilhaften Ausgestaltung weist das Rahmenteil einen Positionierstiftbereich auf, welcher an der Leiterplatte, insbesondere an der von der Halteplatte abgewandten Seite der Leiterplatte, abgestützt ist. Von Vorteil ist dabei, dass das Rahmenteil in allen Raumrichtungen begrenzt angeordnet ist.

Bei einer vorteilhaften Ausgestaltung weist das Rahmenteil auf zumindest einer kürzesten Verbindungslinie zwischen dem Leistungsmodul und dem Wulst zwei voneinander beabstandete Schlitze auf, insbesondere wobei ein erster der beiden Schlitze näher am Leistungsmodul als der zweite der beiden Schlitze angeordnet ist. Von Vorteil ist dabei, dass die Schlitze Längsschlitze sind, welche parallel zu der ihnen nächstliegenden Oberfläche ausgerichtet sind.

Bei einer vorteilhaften Ausgestaltung weist das Leistungsmodul steuerbare Halbleiterschalter, insbesondere IGBT oder MOSFET, auf, eines Wechselrichters aufweist. Von Vorteil ist dabei, dass dem Motor eine Drehspannung zur Verfügung stellbar ist.

Bei einer vorteilhaften Ausgestaltung ist der Wulst von der Leiterplatte beabstandet und das Leistungsmodul sowohl den Kühlkörper, insbesondere die Kontaktfläche des Kühlkörpers, berührt also auch die Leiterplatte. Von Vorteil ist dabei, dass das Leistungsmodul in einfacher Weise zentriert ist.

Bei einer vorteilhaften Ausgestaltung ist die Kontaktfläche eben ausgeführt. Von Vorteil ist dabei, dass ein niedriger Wärmeübergangswiderstand zwischen Kontaktfläche und Leistungsmodul erreichbar ist.

Bei einer vorteilhaften Ausgestaltung ist die Kontaktfläche parallel zur Leiterplatte ausgerichtet,
insbesondere wobei die Positionierstifte senkrecht zur Kontaktfläche ausgerichtet sind. Von Vorteil ist dabei, dass die Positionierstifte in Normalenrichtung der Leiterplattenebene auf Druck belastet sind.

Bei einer vorteilhaften Ausgestaltung wird ein von einem Lüfter geförderter Kühlluftstrom an der von der Kontaktfläche abgewandten Seite des Kühlkörpers entlanggeführt. Von Vorteil ist dabei, dass eine effiziente Kühlung der Wärme erzeugenden Leistungsmoduls erreichbar ist, da die Wärme auf der anderen Seite mittels des geförderten Luftstroms abgeführt wird an die Umgebungsluft.

Bei einer vorteilhaften Ausgestaltung sind Bauelemente einer Signalelektronik auf der vom Leistungsmodul abgewandten Seite der Leiterplatte angeordnet, wobei die Signalelektronik Ansteuersignale erzeugt zur Ansteuerung der steuerbaren Halbleiterschalter des Leistungsmoduls. Von Vorteil ist dabei, dass die Signalelektronik thermisch getrennt ist von dem Leistungsmodul mittels der als Wärmesperre oder zumindest als Wärmewiderstand fungierenden Leiterplatte. Insbesondere das Grundmaterial der Leiterplatte weist einen erheblichen Wärmewiderstand auf, der allerdings mittels Durchkontaktierungen verringert wird. Trotzdem ist mittels der Leiterplatte ein Wärmewiderstand realisiert, der ein Temperaturgefälle zwischen Leistungsmodul und Raumbereich der Signalelektronik bewirkt.

Wichtige Merkmale bei dem Verfahren zum Herstellen eines ersten und zweiten Elektrogeräts aus einem Baukasten sind, dass wahlweise
- entweder das erste Elektrogerät aus dem Rahmenteil, dem Kühlkörper und dem ersten Leistungsmodul hergestellt wird
- oder das zweite Elektrogerät aus dem zweiten Leistungsmodul und dem Kühlkörper hergestellt wird,

insbesondere wobei der Baukasten ein erstes und ein zweites Leistungsmodul aufweist, ein Rahmenteil und einen Kühlkörper, der eine Kontaktfläche aufweist,
insbesondere wobei das jeweilige Elektrogerät ein jeweiliger Wechselrichter oder Umrichter ist,
   (i) wobei zur Herstellung des ersten Elektrogeräts auf dem die Kontaktfläche aufweisenden Kühlkörper das erste Leistungsmodul angeordnet wird, insbesondere mit zwischen Kontaktfläche und erstem Leistungsmodul zwischengeordneter Wärmeleitpaste,
wobei das Rahmenteil auf der Kontaktfläche angeordnet wird, insbesondere aufgelegt wird, wobei das erste Leistungsmodul im Rahmenteil aufgenommen wird,
wobei das Rahmenteil durch einen am Rand der Kontaktfläche hervorragenden Wulst des Kühlkörpers begrenzt wird,
(ii) wobei zur Herstellung des zweiten Elektrogeräts auf dem die Kontaktfläche aufweisenden Kühlkörper, dass weite Leistungsmodul angeordnet wird, insbesondere mit zwischen Kontaktfläche und Leistungsmodul zwischengeordneter Wärmeleitpaste,
wobei das zweite Leistungsmodul durch den am Rand der Kontaktfläche hervorragenden Wulst des Kühlkörpers begrenzt wird.

Von Vorteil ist dabei, dass eine hohe Varianz von Elektrogeräten aus einer geringen Anzahl von Komponenten eines Baukastens herstellbar ist. Denn mittels des kleinen Rahmenteils ist das kleinere erste Leistungsmodul auf derselben Kontaktfläche des Kühlkörpers anordenbar wie das zweite Leistungsmodul. Das Rahmenteil ist als Kunststoffspritzgussteil kostengünstig ausführbar und somit von den Kosten her vernachlässigbar. Im Baukasten, also auch im Lager der Anlage zum Fertigen der Elektrogeräte, ist jedoch nur eine einzige Sorte von Kühlkörpern vorzusehen. Somit sind die Stückzahlen der Kühlkörper groß und somit die Kühlkörper kostengünstig herstellbar.

Bei einer vorteilhaften Ausgestaltung weist derjenige Flächenbereich der Kontaktfläche, an welcher das erste Leistungsmodul die Kontaktfläche berührt, einen kleineren Flächeninhalt auf als derjenige Flächenbereich der Kontaktfläche, an welcher das zweite Leistungsmodul die Kontaktfläche berührt. Von Vorteil ist dabei, dass wahlweise zwei verschieden große Leistungsmodule auf derselben Kontaktfläche anordenbar sind. Somit ist im Baukasten zur Herstellung der Baureihe von Elektrogeräten nur eine Art von Kühlkörper zu bevorraten, also für das Leistungsmodul kleinerer Baugröße ist derselbe Kühlkörper verwendbar, der eigentlich für ein Leistungsmodul größerer Baugröße verwendbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

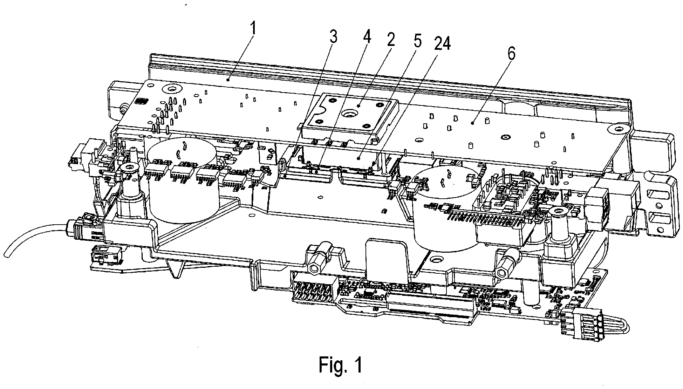

In der Figur 1 ist ein erfindungsgemäßer Umrichter angeschnitten in Schrägansicht dargestellt, der ein Leistungsmodul 5, ein Rahmenteil 4 und eine Leiterplatte 6 aufweist.

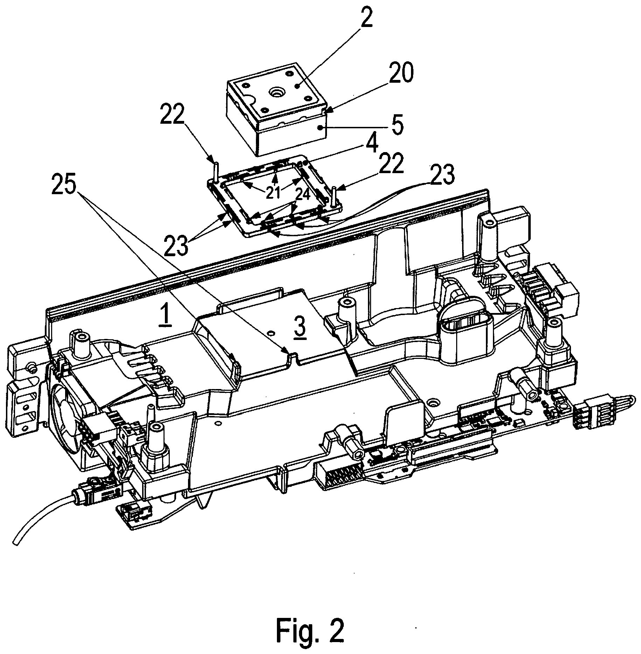

In der Figur 2 ist das Leistungsmodul 5, das Rahmenteil 4 am Umrichter explodiert in Schrägansicht dargestellt, wobei die Leiterplatte 6 ausgeblendet ist.

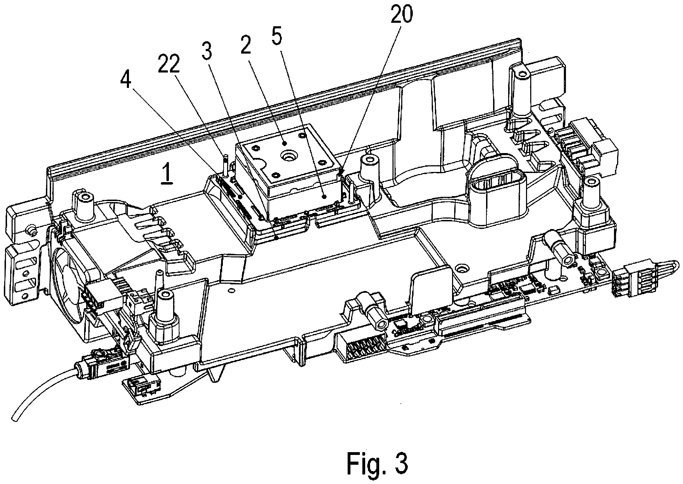

In der Figur 3 ist der angeschnittene Umrichter in Schrägansicht dargestellt, wobei die Leiterplatte 6 ausgeblendet ist.
In der Figur 4 ist das Rahmenteil 4 in Draufsicht dargestellt.

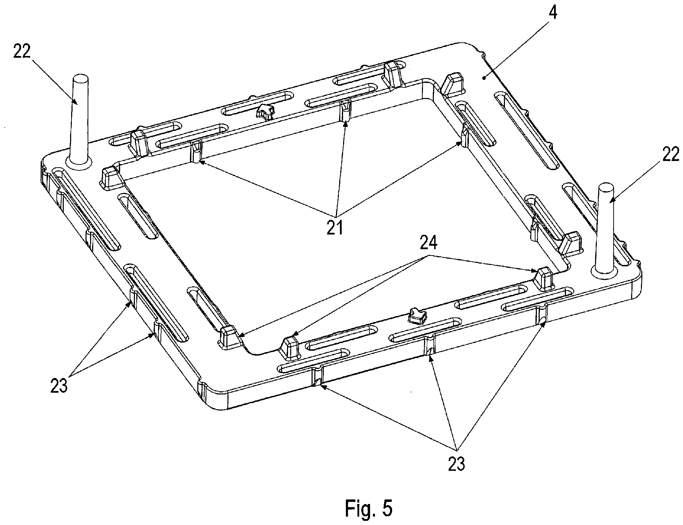

In der Figur 5 ist das Rahmenteil 4 in Schrägansicht dargestellt.

Wie in den Figuren dargestellt, weist der Umrichter ein Gehäuse 1 auf, das mit einem Kühlkörper 3 verbunden ist, der eine zum Innenraum hin angeordnete ebene, insbesondere fein bearbeitete, Kontaktfläche aufweist.

Die Kontaktfläche ist parallel zu der Leiterplatte 6 ausgerichtet, welche beabstandet ist von der Kontaktfläche.

Am Rand der insbesondere im Wesentlichen als Rechteck ausgeführten Kontaktfläche sind am Kühlkörper 3 hervorstehende Begrenzungsnoppen 25 ausgeformt. Diese Begrenzungsnoppen 25 stehen nach oben, also zur Leiterplatte 6 hin, hervor.

Auf die Kontaktfläche ist ein Rahmenteil 4 aufgelegt. Das Rahmenteil 4 ist als Rechteckrahmen ausgeführt und weist dabei in Normalenrichtung einer die Leiterplatte aufnehmenden Ebene durchgehende Längsschlitze auf, so dass das Rahmenteil 4 im die Längsschlitze umgebenden Bereich nur wenig Material aufweist, das somit elastisch in zur Normalenrichtung und zur Schlitzrichtung senkrechten Richtung auslenkbar ist.

Der jeweilige Längsschlitz ist von einem dünnen Steg des Materials begrenzt, wobei der Steg am inneren Rand des Rahmenteils liegt, wenn der zugehörige Schlitzbereich näher am inneren als am äußeren Rand des Rahmenteils angeordnet ist, und einen nach innen vorstehenden Vorsprung 21, insbesondere Nase, aufweist.

Wenn der jeweilige Schlitzbereich jedoch näher am äußeren als am inneren Rand des Rahmenteils angeordnet ist, liegt der Steg am äußeren Rand des Rahmenteils 4 an und weist einen nach außen gerichteten Vorsprung 23, insbesondere Nase, auf.

Am Rand der Kontaktfläche erhebt sich in Normalenrichtung zumindest abschnittsweise ein Wulst, der allerdings von den Begrenzungsnoppen 25 überragt wird.

Der Wulst erhebt sich in Normalenrichtung zumindest gleich oder mehr als die Wandstärke des Rahmenteils 4 in dieser Normalenrichtung beträgt.

Somit ist das Rahmenteil 4 an seinem umlaufenden Rand begrenzt. Zur Begrenzung in Normalenrichtung sind am Rahmenteil 4 Positionierstiftbereiche 22 ausgeformt, welche sich an der Leiterplatte 6 abstützen.

Mittels der Vorsprünge 23 berührt das Rahmenteil 4 den Kühlkörper 3, wobei die Vorsprünge 23 am Wulst des Kühlkörpers 3 abgestützt sind. Die Vorsprünge 23 sind an den die Längsschlitze begrenzenden Stegen ausgeformt und somit elastisch federnd am Rahmenteil 4 angeordnet.

Somit ist das Rahmenteil 4 zwischen der Kontaktfläche des Kühlkörpers 3 und der Leiterplatte 6 in allen Raumrichtungen fixiert.

Das Leistungsmodul 5 weist steuerbare Halbleiterschalter eines Wechselrichters auf, welcher zur Speisung eines Elektromotors vorgesehen ist. Die steuerbaren Halbleiterschalter sind in zueinander parallel geschalteten Halbbrücken angeordnet und werden aus einer Gleichspannung, insbesondere Zwischenkreisspannnung, versorgt. Jede der Halbbrücken stellt an ihrer Mittelanzapfung eine jeweilige der Phasenspannungen der vom Wechselrichter bereit gestellten Wechselspannung, insbesondere Drehspannung, dem Motor zur Verfügung.

Das Leistungsmodul 5 ist im Innenbereich des Rahmenteils 4 aufgenommen, so dass das Leistungsmodul 5 in den zur Normalenrichtung senkrechten Richtungen vom Rahmenteil 4 umgeben ist, wobei das Leistungsmodul 5 das Rahmenteil 4 in Normalenrichtung überragt.

Das Leistungsmodul 5 ist auf der Kontaktfläche aufgesetzt, insbesondere mit zwischengeordneter Wärmeleitpaste.

Die an der Innenseite des Rahmenteils 4 nach innen zum Leistungsmodul 5 hervorragenden Vorsprünge 21, insbesondere Nasen, berühren das Leistungsmodul 5 und tragen zur Positionierung des Leistungsmoduls 5 bei.

An seiner von der Kontaktfläche abgewandten Seite weist das Leistungsmodul 5 einen Positionierstift 20 auf, der durch eine entsprechende Ausnehmung, insbesondere durch ein Loch, der Leiterplatte 6 hindurch in eine Ausnehmung der Halteplatte 2 hineinragt und somit das Leistungsmodul 5 zur Leiterplatte 6 relativ positioniert.

Die auf der vom Leistungsmodul 5 abgewandten Seite der Leiterplatte 6 angeordnete Halteplatte 2 wird mit einer Schraube, welche durch die Leiterplatte 6 hindurchragt, in eine Gewindebohrung des Leistungsmoduls 5 eingeschraubt. Dabei drückt dann der Schraubenkopf der Schraube die Halteplatte 2 auf die Leiterplatte 6 und diese auf die von der Kontaktfläche abgewandte Seite des Leistungsmoduls 5. Somit werden also auch die Leiterplatte 6 und das Leistungsmodul aufeinandergedrückt.

Das Rahmenteil 4 weist zumindest eine diskrete Drehsymmetrie um eine Achse auf mit einem Drehwinkel von 180°, wobei die Achse parallel zur Normalenrichtung ausgerichtet ist und durch den Schwerpunkt des Rahmenteils 4 hindurchgeht.

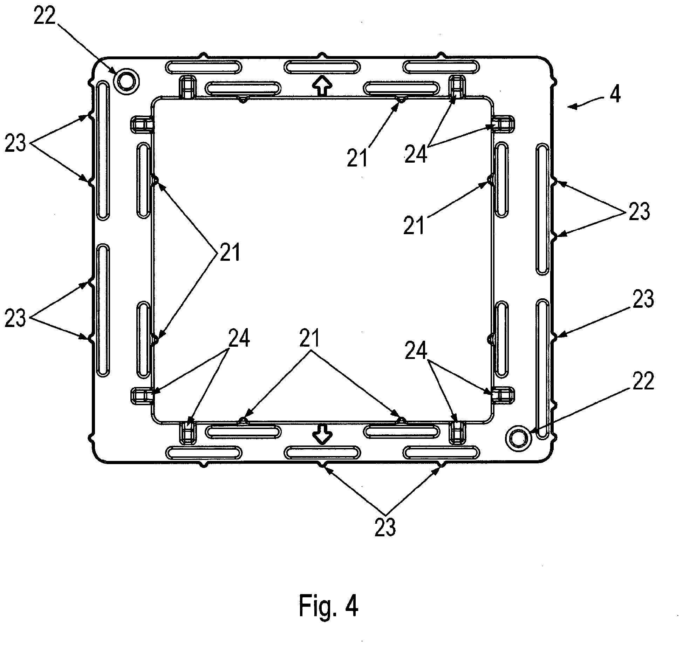

Wie in Figur 4 deutlich gezeigt, sind die Vorsprünge (21, 23) jeweils an einem jeweiligen Steg angeordnet, der einen jeweiligen Schlitz begrenzt, wobei der Schlitz in der vom Schlitz zum zugehörigen Vorsprung hin gerichteten Richtung seine geringste Ausdehnung und senkrecht dazu, insbesondere also in Querrichtung, seine größte Ausdehnung aufweist.

Nicht alle Vorsprünge 23 liegen am Wulst an, insbesondere da der Wulst in Umfangsrichtung nicht ununterbrochen, sondern mit Unterbrechungen umläuft. Somit ist das Rahmenteil 4 auch

für andere Umrichter verwendbar, wo dann die im in den Figuren ungenutzten Vorsprünge 23 genutzt werden, also am dann anders ausgeformten Wulst anliegen.

Bei weiteren erfindungsgemäßen Ausführungsbeispielen wird das Gehäuse 1 und der Kühlkörper 3 einstückig, also einteilig ausgeführt, insbesondere als Aluminium-Gussteil.

Bei weiteren erfindungsgemäßen Ausführungsbeispielen wird ein im Vergleich zum Leistungsmodul 5 größeres Leistungsmodul verwendet, so dass kein Rahmenteil 4 notwendig ist und das Leistungsmodul direkt auf die Kontaktfläche aufsetzbar ist und die am Kühlkörper 3 am Rand der Kontaktfläche ausgeformten und hervorstehenden Begrenzungsnoppen 25 das Leistungsmodul begrenzen und/oder zentrieren.

Bei weiteren erfindungsgemäßen Ausführungsbeispielen ist der Umrichter nur als Wechselrichter ausgeführt, weist also einen gleichspannungsseitigen Anschluss zur Versorgung der steuerbaren Halbleiterschalter des Leistungsmoduls auf. Gegebenenfalls sind für die Gleichrichtung der Spannung eines Wechselspannungsversogungsnetzes ungenutzte Gleichrichterdioden auf dem Leistungsmodul angeordnet. Statt des Umrichters oder Wechselrichters sind auch andere Elektrogeräte mit einem Leistungsmodul von der Erfindung umfasst.

### Bezugszeichenliste

1 Gehäuse
2 Halteplatte
3 Kühlkörper mit ebener, insbesondere fein bearbeiteter Kontaktfläche
4 Rahmenteil
5 Leistungsmodul
6 Leiterplatte
20 Positionierstift
21 Vorsprung, insbesondere Nase
22 Positionierstiftbereich des Rahmenteils 4
23 Vorsprung, insbesondere Nase
24 Begrenzungsnasen
25 Begrenzungsnoppen

## Patentansprüche

1. Elektrogerät, insbesondere Wechselrichter oder Umrichter,
wobei das Elektrogerät einen eine Kontaktfläche aufweisenden Kühlkörper (3) aufweist, auf welchem ein Leistungsmodul (5) angeordnet ist, insbesondere mit zwischen Kontaktfläche und Leistungsmodul (5) zwischengeordneter Wärmeleitpaste,
**wobei** ein Rahmenteil (4) des Elektrogeräts auf der Kontaktfläche angeordnet, insbesondere aufgelegt ist, wobei das Leistungsmodul (5) im Rahmenteil (4) aufgenommen ist,
wobei das Rahmenteil (4) durch einen am Rand der Kontaktfläche hervorragenden Wulst des Kühlkörpers begrenzt ist,
insbesondere wobei der Kühlkörper (3) metallisch und das Rahmenteil (4) aus Kunststoff, insbesondere als Spritzgussteil, ausgeführt ist,
**dadurch gekennzeichnet, dass**
**das Leistungsmodul (5) an der Innenseite des Rahmenteils (4) aufgenommen ist und die Außenseite des Rahmenteils (4) vom Kühlkörper, insbesondere vom Wulst, aufgenommen ist,**
**wobei das Rahmenteil (4) an seiner Außenseite zum am Kühlkörper (3) ausgeformten Wulst hin hervorragende Vorsprünge, insbesondere Nasen, aufweist.**

2. Elektrogerät nach Anspruch 1,
**dadurch gekennzeichnet, dass**
das Leistungsmodul (5) mit einer auf der von der Kontaktfläche abgewandten Seite des Leitungsmoduls angeordneten Leiterplatte (6) elektrisch verbunden ist,
insbesondere wobei Kontakte des Leistungsmoduls (5) zur elektrischen Kontaktierung auf Leiterbahnen der Leiterplatte (6) gedrückt angeordnet sind.

3. Elektrogerät nach Anspruch 2,
**dadurch gekennzeichnet, dass**
auf der von dem Leistungsmodul (5) abgewandten Seite der Leiterplatte (6) eine Halteplatte (2) angeordnet ist, welche, insbesondere von einem Schraubenkopf einer in eine Gewindebohrung des Leistungsmoduls (5), zumindest teilweise eingeschraubten Schraube auf die Leiterplatte (6) gedrückt wird, insbesondere welche somit auf das Leistungsmodul (5) gedrückt wird.

4. Elektrogerät nach einem der vorangegangenen Ansprüche,
**dadurch gekennzeichnet, dass**
das Rahmenteil (4) an seiner Innenseite zum Leistungsmodul (5) hin hervorragende Vorsprünge, insbesondere Nasen, aufweist,
insbesondere wobei mehrere der Vorsprünge das Leistungsmodul (5) berühren.

5. Elektrogerät nach Anspruch 4,
**dadurch gekennzeichnet, dass**
jeder der Vorsprünge an einem jeweiligen Steg angeformt ist, welcher einen jeweiligen Schlitz begrenzt,
insbesondere wobei der jeweilige Schlitz in der vom Schlitz zum Vorsprung (21) gerichteten Richtung weniger ausgedehnt ist als in der zur Richtung senkrechten Richtung.

6. Elektrogerät nach einem der vorangegangenen Ansprüche,
**dadurch gekennzeichnet, dass**
**mehrere dieser Vorsprünge den Wulst berühren,**
**insbesondere wobei der Wulst mehrstückig, also mehrteilig, ausgebildet ist.**

7. Elektrogerät **nach Anspruch 3,**
**dadurch gekennzeichnet, dass**
das Rahmenteil (4) einen Positionierstiftbereich (22) aufweist, welcher an der Leiterplatte (6), insbesondere an der von der Halteplatte (2) abgewandten Seite der Leiterplatte (6), abgestützt ist.

8. Elektrogerät nach einem der vorangegangenen Ansprüche,
**dadurch gekennzeichnet, dass**
das Rahmenteil (4) auf zumindest einer kürzesten Verbindungslinie zwischen dem Leistungsmodul (5) und dem Wulst zwei voneinander beabstandete Schlitze aufweist, insbesondere wobei ein erster der beiden Schlitze näher am Leistungsmodul (5) als der zweite der beiden Schlitze angeordnet ist.

9. Elektrogerät nach Anspruch 2, 3 oder 7,
**dadurch gekennzeichnet, dass**
das Leistungsmodul (5) steuerbare Halbleiterschalter, insbesondere IGBT oder MOSFET, aufweist, eines Wechselrichters aufweist
und/oder dass
der Wulst von der Leiterplatte (6) beabstandet ist und das Leistungsmodul (5) sowohl den Kühlkörper, insbesondere die Kontaktfläche des Kühlkörpers, also auch die Leiterplatte (6) berührt.

10. Elektrogerät nach Anspruch 8,
**dadurch gekennzeichnet, dass**
die Kontaktfläche eben ausgeführt ist
und/oder dass
die Kontaktfläche parallel zur Leiterplatte (6) ausgerichtet ist,
insbesondere wobei die Positionierstifte (20) senkrecht zur Kontaktfläche ausgerichtet sind.

11. Elektrogerät nach einem der vorangegangenen Ansprüche,
**dadurch gekennzeichnet, dass**
ein von einem Lüfter geförderter Kühlluftstrom an der von der Kontaktfläche abgewandten Seite des Kühlkörpers entlanggeführt wird.

12. Elektrogerät nach Anspruch 2, 3 oder 7 oder 9 oder 10,
**dadurch gekennzeichnet, dass**
Bauelemente einer Signalelektronik auf der vom Leistungsmodul (5) abgewandten Seite der Leiterplatte (6) angeordnet sind, wobei die Signalelektronik Ansteuersignale erzeugt zur Ansteuerung der steuerbaren Halbleiterschalter des Leistungsmoduls (5).

13. Verfahren zum Herstellen eines ersten und zweiten Elektrogeräts **nach einem der vorangegangenen Ansprüche** aus Komponenten eines Baukastens,
insbesondere wobei der Baukasten als Komponenten ein erstes und ein zweites Leistungsmodul (5) aufweist, ein Rahmenteil (4) und einen Kühlkörper, der eine Kontaktfläche aufweist,
insbesondere wobei das jeweilige Elektrogerät ein jeweiliger Wechselrichter oder Umrichter ist,
wobei wahlweise
- entweder das erste Elektrogerät durch Zusammenbauen des Rahmenteils (4), des Kühlkörpers und des ersten Leistungsmoduls (5) hergestellt wird
- oder das zweite Elektrogerät durch Zusammenbauen des zweiten Leistungsmoduls (5) und des Kühlkörpers hergestellt wird,
(i) wobei zur Herstellung des ersten Elektrogeräts
- auf dem die Kontaktfläche aufweisenden Kühlkörper (3)das erste Leistungsmodul (5) angeordnet wird, insbesondere mit zwischen Kontaktfläche und erstem Leistungsmodul (5) zwischengeordneter Wärmeleitpaste,
wobei das Rahmenteil (4) auf der Kontaktfläche angeordnet wird, insbesondere aufgelegt wird, wobei das erste Leistungsmodul (5) im Rahmenteil (4) aufgenommen wird,
wobei das Rahmenteil (4) durch einen am Rand der Kontaktfläche hervorragenden Wulst des Kühlkörpers begrenzt wird,
(ii) wobei zur Herstellung des zweiten Elektrogeräts
- auf dem die Kontaktfläche aufweisenden Kühlkörper, dass weite Leistungsmodul (5) angeordnet wird, insbesondere mit zwischen Kontaktfläche und Leistungsmodul (5) zwischengeordneter Wärmeleitpaste,
- **dadurch gekennzeichnet, dass** das zweite Leistungsmodul (5) durch den am Rand der Kontaktfläche hervorragenden Wulst des Kühlkörpers begrenzt wird.

14. Verfahren nach Anspruch 13,
**dadurch gekennzeichnet, dass**
derjenige Flächenbereich der Kontaktfläche, an welcher das erste Leistungsmodul (5) die Kontaktfläche berührt einen kleineren Flächeninhalt aufweist als derjenige Flächenbereich der Kontaktfläche, an welcher das zweite Leistungsmodul (5) die Kontaktfläche berührt.

## Claims

1. Electrical device, in particular an inverter or a converter,
wherein the electrical device comprises a cooling member (3) that has a contact surface and on which a power module (5) is arranged, in particular with thermal paste interposed between the contact surface and the power module (5),
wherein a frame part (4) of the electrical device is arranged, in particular placed, on the contact surface, wherein the power module (5) is received in the frame part (4),
wherein the frame part (4) is delimited by a bead of the cooling member, said bead protruding at the edge of the contact surface,
in particular wherein the cooling member (3) is made of metal and the frame part (4) is made of plastics material, in particular as an injection-moulded part,
**characterised in that**
the power module (5) is received on the inside of the frame part (4), and the outside of the frame part (4) is received by the cooling member, in particular by the bead,
wherein the frame part (4) on its outside comprises projections, in particular lugs, that protrude towards the bead moulded on the cooling member (3).

2. Electrical device according to claim 1,
**characterised in that**
the power module (5) is electrically connected to a printed circuit board (6) arranged on the side of the power module facing away from the contact surface,
in particular wherein contacts of the power module (5) are arranged so as to be pressed on conducting tracks of the printed circuit board (6) for the purpose of electrical contact.

3. Electrical device according to claim 2,
**characterised in that**
on the side of the printed circuit board (6) facing away from the power module (5) there is arranged a retaining plate (2) which is pressed onto the printed circuit board (6), in particular by a screw head of a screw that is at least partly screwed into a threaded bore in the power module (5), and is thus in particular pressed onto the power module (5).

4. Electrical device according to any of the preceding claims,
**characterised in that**
the frame part (4) on its inside comprises projections, in particular lugs, that protrude towards the power module (5),
in particular wherein a plurality of the projections are in contact with the power module (5).

5. Electrical device according to claim 4,
**characterised in that**
each of the projections is formed on a respective ridge delimiting a respective slot,
in particular wherein each slot has less of an extension in the direction from the slot towards the projection (21) than in the direction perpendicular to that direction.

6. Electrical device according to any of the preceding claims,
**characterised in that**
a plurality of these projections are in contact with the bead,
in particular wherein the bead is formed in multiple pieces, i.e. in multiple parts.

7. Electrical device according to claim 3,
**characterised in that**
the frame part (4) comprises a positioning pin region (22) that is supported on the printed circuit board (6), in particular on the side of the printed circuit board (6) facing away from the retaining plate (2).

8. Electrical device according to any of the preceding claims,
**characterised in that**
on at least one shortest connecting line between the power module (5) and the bead, the frame part (4) comprises two slots arranged at a distance from one another, in particular wherein a first of the two slots is arranged closer to the power module (5) than the second of the two slots.

9. Electrical device according to claim 2, claim 3 or claim 7,
**characterised in that**
the power module (5) comprises controllable semiconductor switches, in particular IGBTs or MOSFETs, of an inverter
and/or **in that**
the bead is arranged at a distance from the printed circuit board (6), and the power module (5) is in contact with both the cooling member, in particular the contact surface of the cooling member, and the printed circuit board (6).

10. Electrical device according to claim 8,
**characterised in that**
the contact surface is configured in a planar manner
and/or **in that**
the contact surface is oriented in parallel with the printed circuit board (6),
in particular wherein the positioning pins (20) are oriented perpendicularly to the contact surface.

11. Electrical device according to any of the preceding claims,
**characterised in that**
a cooling air stream conveyed by a fan is guided along the side of the cooling member facing away from the contact surface.

12. Electrical device according to claim 2, claim 3 or claim 7 or claim 9 or claim 10,
**characterised in that**
elements of signal electronics are arranged on the side of the printed circuit board (6) facing away from the power module (5), wherein the signal electronics generate actuation signals for actuating the controllable semiconductor switches of the power module (5).

13. Method for producing a first and a second electrical device according to any of the preceding claims from components of a kit,
in particular wherein the kit comprises as components a first and a second power module (5), a frame part (4) and a cooling member having a contact surface,
in particular wherein each electrical device is a particular inverter or converter, wherein, selectively,
- either the first electrical device is produced by assembling the frame part (4), the cooling member and the first power module (5)
- or the second electrical device is produced by assembling the second power module (5) and the cooling member,
(i) wherein, to produce the first electrical device,
- the first power module (5) is arranged on the cooling member (3) having the contact surface, in particular with thermal paste interposed between the contact surface and the first power module (5),
wherein the frame part (4) is arranged, in particular placed, on the contact surface, wherein the first power module (5) is received in the frame part (4),
wherein the frame part (4) is delimited by a bead of the cooling member, said bead protruding at the edge of the contact surface,
(ii) wherein, to produce the second electrical device,
- the second power module (5) is arranged on the cooling member having the contact surface, in particular with thermal paste interposed between the contact surface and the power module (5),
- **characterised in that** the second power module (5) is delimited by the bead of the cooling member, said bead protruding at the edge of the contact surface.

14. Method according to claim 13,
**characterised in that**
that surface region of the contact surface on which the first power module (5) is in contact with the contact surface has a smaller area than that surface region of the contact surface on which the second power module (5) is in contact with the contact surface.

## Revendications

1. Appareil électrique, en particulier onduleur ou convertisseur,
l'appareil électrique présentant un dissipateur thermique (3) muni d'une surface de contact et sur lequel est agencé un module de puissance (5), de la pâte conductrice de chaleur étant en particulier agencée entre la surface de contact et le module de puissance (5),
une partie cadre (4) de l'appareil électrique étant agencée, en particulier posée, sur la surface de contact, le module de puissance (5) étant logé dans la partie cadre (4),
la partie cadre (4) étant délimitée au niveau du bord de la surface de contact par un renflement saillant du dissipateur thermique,
le dissipateur de chaleur (3) étant en particulier métallique et la partie cadre (4) étant en particulier en matière plastique, en particulier sous forme de pièce moulée par injection,
**caractérisé en ce que**
le module de puissance (5) est accueilli sur la face intérieure de la partie cadre (4) et la face extérieure de la partie cadre (4) est accueillie par le dissipateur de chaleur, en particulier par le renflement,
la partie cadre (4) présentant sur sa face extérieure des avancées, en particulier des ergots, faisant saillie en direction du renflement formé au niveau du dissipateur de chaleur (3).

2. Appareil électrique selon la revendication 1,
**caractérisé en ce que**
le module de puissance (5) est connecté électriquement à une carte de circuit imprimé (6) agencée sur le côté du module de puissance qui est opposé à la surface de contact,
des contacts du module de puissance (5) étant en particulier pressés sur les pistes conductrices de la carte de circuit imprimé (6) afin de créer un contact électrique.

3. Appareil électrique selon la revendication 2,
**caractérisé en ce que**
sur le côté de la carte de circuit imprimé (6) qui est opposé au module de puissance (5) est agencée une plaque de retenue (2) qui est pressée sur la carte de circuit imprimé (6), en particulier qui est ainsi pressée sur le module de puissance (5), en particulier par une tête de vis d'une vis vissée au moins partiellement dans un alésage fileté du module de puissance (5).

4. Appareil électrique selon l'une quelconque des revendications précédentes,
**caractérisé en ce que**
la partie cadre (4) présente sur sa face intérieure des avancées, en particulier des ergots, faisant saillie en direction du module de puissance (5),
plusieurs des avancées étant en particulier en contact avec le module de puissance (5).

5. Appareil électrique selon la revendication 4,
**caractérisé en ce que**
chacune des avancées est formée au niveau d'une barrette respective qui délimite une fente respective,
la fente respective étant en particulier moins étendue dans la direction allant de la fente vers l'avancée (21) que dans la direction perpendiculaire à ladite direction.

6. Appareil électrique selon l'une quelconque des revendications précédentes,
**caractérisé en ce que**
plusieurs desdites avancées sont en contact avec le renflement,
le renflement étant en particulier réalisé en plusieurs morceaux, c'est-à-dire en plusieurs parties.

7. Appareil électrique selon la revendication 3,
**caractérisé en ce que**
la partie cadre (4) présente une région de broche de positionnement (22) qui s'appuie sur la carte de circuit imprimé (6), en particulier sur le côté de la carte de circuit imprimé (6) qui est opposé à la plaque de retenue (2).

8. Appareil électrique selon l'une quelconque des revendications précédentes,
**caractérisé en ce que**
la partie cadre (4) présente deux fentes espacées l'une de l'autre sur au moins une ligne de liaison la plus courte entre le module de puissance (5) et le renflement, une première des deux fentes étant en particulier agencée plus près du module de puissance (5) que la seconde des deux fentes.

9. Appareil électrique selon la revendication 2, 3 ou 7,
**caractérisé en ce que**
le module de puissance (5) présente des commutateurs commandables à semi-conducteurs, en particulier IGBT ou MOSFET, d'un onduleur
et/ou **en ce que**
le renflement se trouve à distance de la carte de circuit imprimé (6) et le module de puissance (5) est en contact à la fois avec le dissipateur de chaleur, en particulier avec la surface de contact du dissipateur de chaleur, et avec la carte de circuit imprimé (6).

10. Appareil électrique selon la revendication 8,
**caractérisé en ce que**
la surface de contact est réalisée de manière plane
et/ou **en ce que**
la surface de contact est orientée parallèlement à la carte de circuit imprimé (6),
les broches de positionnement (20) étant en particulier orientées perpendiculairement à la surface de contact.

11. Appareil électrique selon l'une quelconque des revendications précédentes,
**caractérisé en ce que**
un flux d'air de refroidissement refoulé par un ventilateur est guidé le long du côté du dissipateur de chaleur qui est opposé à la surface de contact.

12. Appareil électrique selon la revendication 2, 3 ou 7 ou 9 ou 10,
**caractérisé en ce que**
les composants structuraux d'une électronique de signal sont agencés sur le côté de la carte de circuit imprimé (6) qui est opposé au module de puissance (5), l'électronique de signal générant des signaux de commande permettant de commander les commutateurs commandables à semi-conducteurs du module de puissance (5).

13. Procédé de fabrication d'un premier et d'un second appareil électrique selon l'une quelconque des revendications précédentes, à partir de composants d'un ensemble modulaire,
l'ensemble modulaire présentant en particulier des premier et second modules de puissance (5), une partie cadre (4) et un dissipateur thermique présentant une surface de contact, qui font office de composants,
l'appareil électrique respectif étant en particulier un onduleur ou un convertisseur respectif,
dans lequel au choix
- le premier appareil électrique est fabriqué en assemblant la partie cadre (4), le dissipateur de chaleur et le premier module de puissance (5)
- ou bien le second appareil électrique est fabriqué en assemblant le second module de puissance (5) et le dissipateur de chaleur,
(i) où, pour la fabrication du premier appareil électrique
- le premier module de puissance (5) est agencé sur le dissipateur thermique (3) présentant la surface de contact, en particulier avec de la pâte conductrice de chaleur interposée entre la surface de contact et le premier module de puissance (5),
la partie cadre (4) étant agencée, en particulier étant posée, sur la surface de contact, le premier module de puissance (5) étant accueilli dans la partie cadre (4),
la partie cadre (4) étant délimitée par un renflement, faisant saillie sur le bord de la surface de contact, du dissipateur thermique
(ii) où, pour la fabrication du second appareil électrique,
- le module de puissance (5) large est agencé sur le dissipateur thermique présentant la surface de contact, en particulier avec de la pâte conductrice de chaleur interposée entre la surface de contact et le module de puissance (5),
- **caractérisé en ce que** le second module de puissance (5) est limité par le renflement, faisant saillie sur le bord de la surface de contact, du dissipateur thermique.

14. Procédé selon la revendication 13,
**caractérisé en ce que**
la région de la surface de contact au niveau de laquelle le premier module de puissance (5) est en contact avec la surface de contact présente une surface plus petite que la région de la surface de contact au niveau de laquelle le second module de puissance (5) est en contact avec la surface de contact.
